# EUROPEAN PATENT SPECIFICATION

(11) **EP 1 272 265 B1**
(45) Date of publication and mention of the grant of the patent: **04.10.2006**
(21) Application number: 01917364.0
(22) Date of filing: 02.04.2001
(51) Int. Cl.: B01J 3/06

(54) **HIGH TEMPERATURE/HIGH PRESSURE COLOUR CHANGE OF DIAMOND**
HOCHTEMPERATUR/HOCHDRUCK-FARBEVERÄNDERUNG VON DIAMANTEN
CHANGEMENT SOUS HAUTE PRESSION/TEMPERATURE ELEVEE DE LA COULEUR DU DIAMANT

(30) Priority: 31.03.2000 GB 0007889; 17.04.2000 GB 0009488
(43) Date of publication of application: 08.01.2003
(73) Proprietor: Element Six (Proprietary) Limited, 1559 Gauteng (ZA)
(72) Inventor: BURNS, Robert, Charles, 2195 Northcliff (ZA); FISHER, David, Berkshire SL6 5EP (GB); SPITS, Raymond, Anthony, 2194 Johannesburg (ZA)
(74) Representative: Talbot-Ponsonby, Daniel Frederick
(86) International application number: PCT/IB2001/000540
(87) International publication number: WO 2001/072406

(56) References cited:
- WO-A-01/14050
- GB-A- 1 578 987
- ALAN T. COLLINS ET AL.: "Colour changes produced in natural brown diamonds by high-pressure, high-temperature treatment" DIAMOND AND RELATED MATERIALS, vol. 9, no. 2, March 2000 (2000-03), pages 113-122, XP004195517 AMSTERDAM., NL ISSN: 0925-9635
- K. SCHMETZER : "BEHANDLUNG NATUERLICHER DIAMANTEN ZUR REDUZIERUNG DER GELB- ODER BRAUNSAETTIGUNG" GOLDSCHMIEDE ZEITUNG, vol. 97, no. 5, 1999, pages 47-48, XP000997186 stuttgart, de ISSN: 0017-1689
- A. V. NIKITIN ET AL.: "The Effect of Heat and Pressure on Certain Physical Properties of Diamonds" SOVIET PHYSICS - DOKLADY, vol. 13, no. 7, January 1969 (1969-01), pages 842-844, XP001019666 New York, US
- S. C. LAWSON & H. KANDA: "Nickel in Diamond: An Annealing Study" DIAMOND AND RELATED MATERIALS., vol. 2, 1993, pages 130-135, XP001015642 ELSEVIER SCIENCE PUBLISHERS, AMSTERDAM., NL ISSN: 0925-9635
- T. EVANS & P. RAINEY: "CHANGES IN THE DEFECT STRUCTURE OF DIAMOND DUE TO HIGH TEMPERATURE +HIGH PRESSURE TREATMENT" PROCEEDINGS OF THE ROYAL SOCIETY OF LONDON, vol. 344, 1975, pages 111-130,A,B, XP000965244 London, GB ISSN: 0080-4649

## Description

### BACKGROUND OF THE INVENTION

This invention relates to a method of changing the colour of a diamond, including the steps of creating a reaction mass by providing the diamond in a pressure transmitting medium which completely encloses the diamond, and subjecting the reaction mass to high temperature and pressure for a suitable period of time.

Diamonds are generally classified into four main types: Ia, Ib, IIa and IIb. These types are usually distinguished by infrared and ultraviolet spectra. Type Ia and Ib diamonds contain nitrogen in a combination of different forms. Type Ib contains single substitutional nitrogen or C-centres. Ia contains a combination of various nitrogen structures. Type IIa diamonds have a nitrogen content of less than a few parts per million (ppm) and can be defined as those diamonds which show substantially no absorption in the 1332 - 400 cm⁻¹ range when irradiated with infrared radiation. Type IIa diamond can exhibit a brown colour caused, it is believed, by structural deformation within the diamond crystal lattice.

US 4, 124,690 describes a process for converting type Ib nitrogen into type Ia nitrogen in type Ib diamond by high temperature annealing under a pressure which prevents graphitisation. This treatment has the effect of reducing the yellow colour of the type Ib diamond.

### SUMMARY OF THE INVENTION

According to the present invention, there is provided a method as set forth in Claim 1. The remaining claims set forth preferred or optional features of the invention.

The period of time during which the diamond is subjected to the conditions of step (ii) referred to in Claim 1 will generally be longer the lower the temperature used in the range described above. The period of heat treatment will generally not exceed 5 hours. The preferred conditions for step (ii) are a temperature in the range 2500°C to 2550°C for a period of up to 90 minutes. Examples of suitable conditions for step (ii) are:
2500°C for a period of 1 hour
2300°C for a period of 5 hours.

The reaction mass may also be subjected to a two-stage heat treatment in step (ii). In a first stage, the reaction mass is subjected to a temperature in the range 1900°C to 2300°C under a pressure of 6,9GPa to 8,5GPa for a suitable period of time and thereafter subjected to a higher temperature in the range described above. In the first stage, the diamond colour is changed to a pink or a lighter brown and in the second stage the diamond colour is changed from pink or a lighter brown to colourless. In this form of the invention, the first stage heat treatment will typically be for a period ranging from 10 minutes to 10 hours, preferably 20 minutes to 4 hours. The preferred temperature is in the range 2100°C to 2300°C, and the preferred pressure is 7,4GPa to 8,5GPa. The second stage heat treatment is preferably maintained for a period of up to 90 minutes and typically about 1 hour. Longer times of up to 5 hours may be used, but are generally not desirable because of the high temperatures applied in this stage. The preferred temperature is 2500°C to 2550°C and the preferred pressure is 8,4GPa to 8,6GPa, in the second stage.

### DESCRIPTION OF EMBODIMENTS

In the present invention, a brown type IIa diamond crystal, which will generally be natural diamond, is annealed under a pressure which prevents significant graphitisation in order to modify the structural deformation which gives rise to the brown colouration and thereby reduce the brown colour and produce a colourless diamond. The two stage annealing process for step (ii) described above allows the colour change to occur in a controlled manner, limiting possible damage to the diamond.

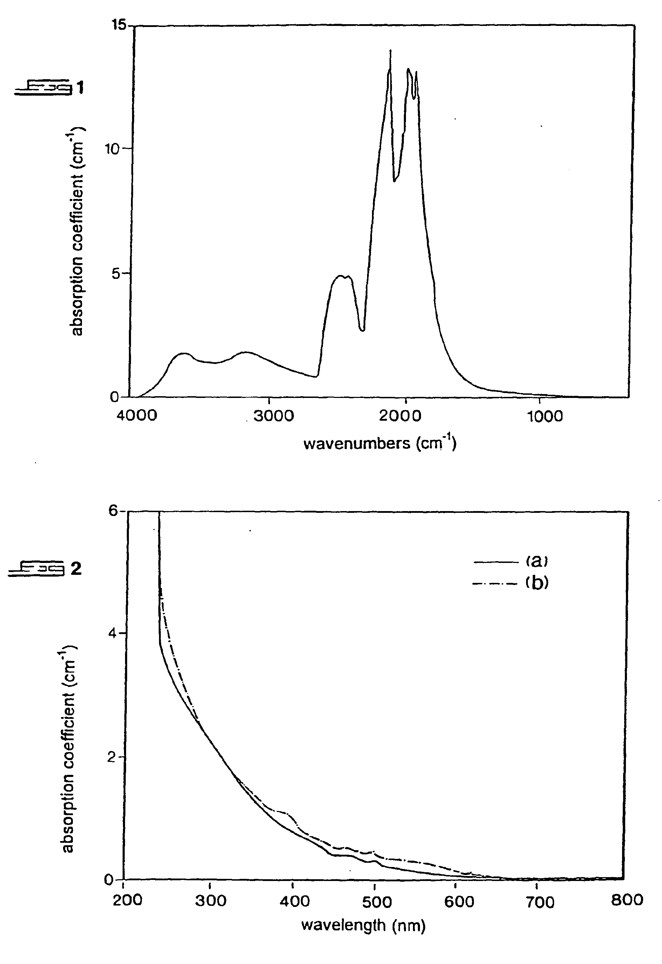

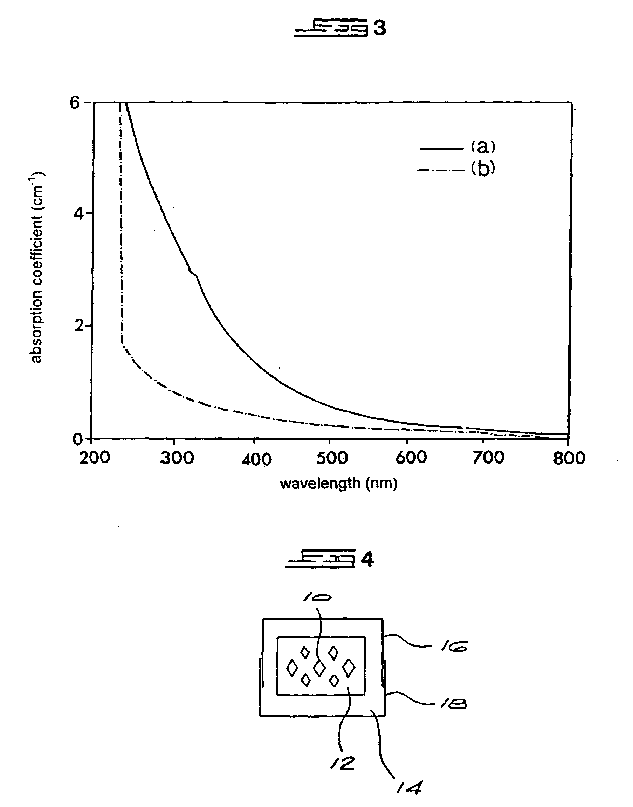

The typical infrared absorption spectrum of a type IIa diamond is shown in Figure 1. However, it is not all type IIa diamonds which are suitable for colour enhancement by high temperature and high pressure treatment of the present invention. The diamonds must have a brown colour which can vary from deep to light brown, including e.g. pinkish brown. Those type IIa diamonds that are most suitable for the present invention have a nitrogen concentration of less than 2 ppm, preferably less than 0,2 ppm, exhibit a brown to pinkish brown colour and have a typical ultraviolet / visible absorption spectrum as shown in Figure 2 in graph line a, which shows a monotonically rising absorption, or a monotonically rising absorption with broad bands centred about 390 and 550 nm as shown in Figure 2 in graph line b.

The change in colour of the type IIa diamond crystal can be quantified by the changes in the absorption spectrum of the crystal taken before and after annealing. Spectra are taken of the crystal at room temperature by means of a spectrometer in a conventional manner showing the ultraviolet / visible absorption spectrum of the crystal. After the crystal is annealed, spectra are taken of it again at room temperature.

Subjecting such diamonds to the method of this invention results in a reduction or effective removal of both of the monotonically rising absorption and the absorption bands at 390nm and 550nm resulting in an effectively colourless diamond. If the two stage heat treatment is used, there will be a reduction of strength of the monotonically rising absorption and the production or the enhancement of the strength of the broad absorption bands at 390 and 550 nm in the first stage.

In the method of the invention, a reaction mass is created by providing diamond in a pressure transmitting medium which completely encloses a diamond. The pressure transmitting medium is preferably a homogeneous pressure transmitting medium which evenly spreads the pressure which is applied over the entire surface of the diamond which is being treated. Examples of suitable mediums are those which have a low shear strength such as metal halide salts. Examples of suitable metal halide salts are potassium bromide, sodium chloride, potassium chloride, caesium chloride, caesium bromide, copper chloride and copper bromide. Such mediums have been found to provide the desirable even spread of pressure which ensures that any graphitisation which may occur on the diamond surface is kept to a minimum. A particular advantage of using a metal halide salt as the pressure transmitting medium is that the diamonds can be easily recovered after treatment by dissolving the medium in hot water.

The method of the invention may be used to treat a single diamond or a plurality of discrete diamonds. If a plurality of discrete diamonds are treated simultaneously, each diamond should be separated from its neighbours by the pressure transmitting medium. The maximum volume of diamond which may be treated is limited only by the capacity of the high pressure/high temperature apparatus used.

Conventional high temperature/high pressure apparatus may be used in the method of the invention. Various reaction vessel configurations which provide for indirect or direct heating of the reaction mass are disclosed in the patent literature and are useful in carrying out the present annealing process. These reaction vessels usually consist of a plurality of interfitting cylindrical members and end plugs or discs for containing the reaction mass in the centremost cylinder. In the indirectly heated type of reaction vessel one of the cylindrical members is made of graphite which is heated by the passage of electric current therethrough and which thereby heats the reaction mass. In the directly heated type of reaction vessel, the reaction mass is electrically conductive, thereby eliminating the need for an electrically conductive graphite cylinder, and electric current is passed directly through the reaction mass to heat it.

The invention is illustrated by the following example.

### EXAMPLE 1

A natural brown type IIa diamond, with the ultraviolet / visible absorption spectrum before treatment shown in Figure 3 in graph line a, was used. A plurality of such diamonds were placed in a pressure transmitting medium in a reaction vessel of the type illustrated by Figure 4. Referring to this figure, the diamond crystals 10 are placed in a pressure transmitting medium 12 such that the crystals are discrete and separated from each other in the pressure transmitting medium. The diamonds are preferably evenly dispersed in the medium. The pressure transmitting medium is preferably a low shear strength medium of the type described above. The diamond-containing medium 12 is placed in a container 14 made of graphite, pyrophyllite, magnesium oxide or zirconium oxide, which is enclosed by co-operating metal cups 16, 18 which form a metal canister around the container 14. The metal may be molybdenum, tantalum or steel. The canister may be compacted around the container to eliminate air voids. The loaded canister is now placed in the reaction zone of a conventional high temperature/high pressure apparatus. The contents of the capsule were subjected to a temperature of 2250°C and a pressure of 7,8GPa which conditions were maintained for a period of 4 hours. The contents of the capsule were thereafter subjected to a temperature of 2550°C and held at this temperature for 1 hour at a pressure of 8,6GPa. The capsule was removed from the apparatus and allowed to cool. The canister and graphite container were removed and the diamonds recovered from the medium. The ultraviolet / visible absorption spectrum of the diamond after treatment is shown in Figure 3 in graph line b. The spectrum shows a significant reduction in absorption and the diamond can be regarded as colourless.

## Claims

1. A method of changing the colour of a diamond, including the steps of:
i) creating a reaction mass by providing the diamond in a pressure transmitting medium which completely encloses the diamond; and
ii) subjecting the reaction mass to high temperature and pressure for a suitable period of time;
**characterised in that** the diamond is a brown type IIa diamond, its colour is changed from brown to colourless, and the reaction mass is subjected to a temperature in the range 2200°C to 2600°C under a pressure of 7.6 GPa to 9 GPa.

2. A method according to claim 1, wherein the diamond is natural diamond.

3. A method according to claim 1 or claim 2, wherein the diamond has a nitrogen concentration of less than 2 ppm, exhibits brown to pinkish brown colour and has an ultraviolet/visible absorption spectrum which shows a monotonically rising absorption, or a monotonically rising absorption with broad bands centred about 390 and 550 nm.

4. A method according to claim 3, wherein the nitrogen concentration is less than 0.2 ppm.

5. A method according to any of the preceding claims, wherein the diamond initially has an ultraviolet/visible absorption spectrum which shows a monotonically rising absorption and has absorption bands centred about 390 and 550 nm, and, after being subjected to step (ii), has a reduction or effective removal of both the monotonically rising absorption and of the absorption bands centred about 390 and 550 nm.

6. A method according to any of the preceding claims, wherein the temperature in step (ii) is in the range of 2500°C to 2550°C.

7. A method according to any of the preceding claims, wherein the period during which the diamond is subjected to the conditions of step (ii) does not exceed 5 hours.

8. A method according to any of the preceding claims, wherein the period during which the diamond is subjected to the conditions of step (ii) does not exceed 90 minutes.

9. A method according to any of the preceding claims, wherein the reaction mass in step (ii) is subjected to a two-stage heat treatment, the reaction mass being subjected, in a second stage, to a higher temperature than in a first stage, in the range set out in claim 1.

10. A method according to claim 9, wherein in the first stage, the diamond colour is changed to a pink or a lighter brown and in the second stage the diamond colour is changed from pink or a lighter brown to colourless.

11. A method according to claim 9 or 10, wherein the reaction mass in step (ii) is subjected, in the first stage, to a temperature in the range 1900°C to 2300°C.

12. A method according to claim 9 or 10, wherein the reaction mass in step (ii) is subjected, in the first stage, to a temperature in the range 2100°C to 2300°C.

13. A method according to claim 9 or 10, wherein the reaction mass in step (ii) is subjected, in the first stage, to a temperature of up to 2300°C.

14. A method according to any of claims 9 to 13, wherein the reaction mass in step (ii) is subjected, in the first stage, to a pressure of 6.9 GPa to 8.5 GPa.

15. A method according to any of claims 9 to 13, wherein the reaction mass in step (ii) is subjected, in the first stage, to a pressure of 7.4 GPa to 8.5 GPa.

16. A method according to any of claims 9 to 13, wherein the reaction mass in step (ii) is subjected, in the first stage, to a pressure of up to 8.5 GPa.

17. A method according to any of claims 9 to 16, wherein the period of heat treatment in the first stage is 10 minutes to 10 hours.

18. A method according to any of claims 9 to 16, wherein the period of heat treatment in the first stage is 20 minutes to 4 hours.

19. A method according to any of claims 9 to 18, wherein the temperature of heat treatment in the second stage is 2500°C to 2550°C.

20. A method according to any of claims 9 to 18, wherein the reaction mass in step (ii) is subjected, in the second stage, to a pressure of 8.4 GPa to 8.6 GPa.

21. A method according to any of claims 9 to 20, wherein the period of heat treatment in the second stage is up to 5 hours.

22. A method according to any of claims 9 to 20, wherein the period of heat treatment in the second stage is up to 90 minutes.

23. A method according to any of claims 9 to 20, wherein the period of heat treatment in the second stage is about 1 hour.

24. A method according to any of the preceding claims, wherein a plurality of diamonds is placed in the pressure transmitting medium, each diamond being separated from its neighbour by pressure transmitting medium.

25. A method according to any of the preceding claims, wherein the pressure transmitting medium is a homogeneous medium which completely encloses the or each diamond and is applied over the entire surface of the or each diamond.

26. A method according to any of the preceding claims, wherein the pressure transmitting medium has a low shear strength.

27. A method according to any of the preceding claims, wherein the pressure transmitting medium is water soluble.

28. A method according to any of the preceding claims, wherein the pressure transmitting medium is a metal halide salt.

29. A method according to claim 28, wherein the halide is bromide or chloride.

30. A method according to any of claims 1 to 25, wherein the pressure transmitting medium is potassium bromide.

31. A method according to any of claims 1 to 25, wherein the pressure transmitting medium is sodium chloride.

32. A method according to any of claims 1 to 25, wherein the pressure transmitting medium is potassium chloride.

33. A method according to any of claims 1 to 25, wherein the pressure transmitting medium is caesium chloride.

34. A method according to any of claims 1 to 25, wherein the pressure transmitting medium is caesium bromide.

35. A method according to any of claims 1 to 25, wherein the pressure transmitting medium is copper chloride.

36. A method according to any of claims 1 to 25, wherein the pressure transmitting medium is copper bromide.

## Patentansprüche

1. Verfahren zur Änderung der Farbe eines Diamanten, mit den folgenden Schritten:
i) Erzeugen einer Reaktionsmasse durch Bereitstellen des Diamanten in einem druckübertragenden Medium, das den Diamanten vollständig einschließt; und
ii) Einwirkenlassen einer hohen Temperatur und eines hohen Drucks auf die Reaktionsmasse während eines geeigneten Zeitraums;
**dadurch gekennzeichnet, daß** der Diamant ein brauner Diamant vom Typ IIa ist; seine Farbe von braun nach farblos verändert wird und die Reaktionsmasse einer Temperatur im Bereich von 2200°C bis 2600°C unter einem Druck von 7,6 GPa bis 9 GPa ausgesetzt wird.

2. Verfahren nach Anspruch 1, wobei der Diamant ein Naturdiamant ist.

3. Verfahren nach Anspruch 1 oder Anspruch 2, wobei der Diamant eine Stickstoffkonzentration von weniger als 2 ppm, braune bis rosabraune Farbe und ein Absorptionsspektrum im ultravioletten/sichtbaren Bereich mit einer monoton ansteigenden Absorption oder einer monoton ansteigenden Absorption mit breiten Banden aufweist, die um etwa 390 nm und 550 nm zentriert sind.

4. Verfahren nach Anspruch 3, wobei die Stickstoffkonzentration weniger als 0,2 ppm beträgt.

5. Verfahren nach einem der vorstehenden Ansprüche, wobei der Diamant zunächst ein Absorptionsspektrum im ultravioletten/sichtbaren Bereich aufweist, das eine monoton ansteigende Absorption und um etwa 390 nm und 550 nm zentrierte Absorptionsbanden aufweist, und nach Durchführung des Schritts (ii) eine Verminderung oder effektive Entfernung sowohl der monoton ansteigenden Absorption als auch der um etwa 390 nm und 550 nm zentrierten Absorptionsbanden aufweist.

6. Verfahren nach einem der vorstehenden Ansprüche, wobei die Temperatur im Schritt (ii) im Bereich von 2500°C bis 2550°C liegt.

7. Verfahren nach einem beliebigen der vorstehenden Ansprüche, wobei der Zeitraum, während dessen der Diamant den Bedingungen von Schritt (ii) ausgesetzt wird, 5 Stunden nicht überschreitet.

8. Verfahren nach einem beliebigen der vorstehenden Ansprüche, wobei der Zeitraum, während dessen der Diamant den Bedingungen von Schritt (ii) ausgesetzt wird, 90 Minuten nicht überschreitet.

9. Verfahren nach einem beliebigen der vorstehenden Ansprüche, wobei die Reaktionsmasse im Schritt (ii) einer zweistufigen Wärmebehandlung ausgesetzt wird, wobei die Reaktionsmasse in einer zweiten Stufe in dem in Anspruch 1 dargelegten Bereich einer höheren Temperatur ausgesetzt wird als in einer ersten Stufe.

10. Verfahren nach Anspruch 9, wobei die Farbe des Diamanten in der ersten Stufe in rosa oder ein helleres Braun übergeht und sich in der zweiten Stufe von rosa oder einem helleren Braun zu farblos verändert.

11. Verfahren nach Anspruch 9 oder 10, wobei die Reaktionsmasse im Schritt (ii) in der ersten Stufe einer Temperatur im Bereich von 1900°C bis 2300°C ausgesetzt wird.

12. Verfahren nach Anspruch 9 oder 10, wobei die Reaktionsmasse im Schritt (ii) in der ersten Stufe einer Temperatur im Bereich von 2100°C bis 2300°C ausgesetzt wird.

13. Verfahren nach Anspruch 9 oder 10, wobei die Reaktionsmasse im Schritt (ii) in der ersten Stufe einer Temperatur im Bereich bis zu 2300°C ausgesetzt wird.

14. Verfahren nach einem der Ansprüche 9 bis 13, wobei die Reaktionsmasse im Schritt (ii) in der ersten Stufe einem Druck von 6,9 GPa bis 8,5 GPa ausgesetzt wird.

15. Verfahren nach einem der Ansprüche 9 bis 13, wobei die Reaktionsmasse im Schritt (ii) in der ersten Stufe einem Druck von 7,4 GPa bis 8,5 GPa ausgesetzt wird.

16. Verfahren nach einem der Ansprüche 9 bis 13, wobei die Reaktionsmasse im Schritt (ii) in der ersten Stufe einem Druck bis zu 8,5 GPa ausgesetzt wird.

17. Verfahren nach einem der Ansprüche 9 bis 16, wobei der Wärmebehandlungszeitraum in der ersten Stufe 10 Minuten bis 10 Stunden beträgt.

18. Verfahren nach einem der Ansprüche 9 bis 16, wobei der Wärmebehandlungszeitraum in der ersten Stufe 20 Minuten bis 4 Stunden beträgt.

19. Verfahren nach einem der Ansprüche 9 bis 18, wobei die Temperatur der Wärmebehandlung in der zweiten Stufe 2500°C bis 2550°C beträgt.

20. Verfahren nach einem der Ansprüche 9 bis 18, wobei die Reaktionsmasse im Schritt (ii) in der zweiten Stufe einem Druck von 8,4 GPa bis 8,6 GPa ausgesetzt wird.

21. Verfahren nach einem der Ansprüche 9 bis 20, wobei der Wärmebehandlungszeitraum in der zweiten Stufe bis zu 5 Stunden beträgt.

22. Verfahren nach einem der Ansprüche 9 bis 20, wobei der Wärmebehandlungszeitraum in der zweiten Stufe bis zu 90 Minuten beträgt.

23. Verfahren nach einem der Ansprüche 9 bis 20, wobei der Wärmebehandlungszeitraum in der zweiten Stufe etwa 1 Stunde beträgt.

24. Verfahren nach einem beliebigen der vorstehenden Ansprüche, wobei mehrere Diamanten in das druckübertragende Medium eingebracht werden, wobei jeder Diamant durch druckübertragendes Medium von seinem Nachbarn getrennt ist.

25. Verfahren nach einem beliebigen der vorstehenden Ansprüche, wobei das druckübertragende Medium ein homogenes Medium ist, das den oder jeden Diamanten vollständig einschließt und über der gesamten Oberfläche des oder jedes Diamanten aufgebracht wird.

26. Verfahren nach einem beliebigen der vorstehenden Ansprüche, wobei das druckübertragende Medium eine niedrige Scherfestigkeit aufweist.

27. Verfahren nach einem beliebigen der vorstehenden Ansprüche, wobei das druckübertragende Medium wasserlöslich ist.

28. Verfahren nach einem beliebigen der vorstehenden Ansprüche, wobei das druckübertragende Medium ein Metallhalogenidsalz ist.

29. Verfahren nach Anspruch 28, wobei das Halogenid Bromid oder Chlorid ist.

30. Verfahren nach einem der Ansprüche 1 bis 25, wobei das druckübertragende Medium Kaliumbromid ist.

31. Verfahren nach einem der Ansprüche 1 bis 25, wobei das druckübertragende Medium Natriumchlorid ist.

32. Verfahren nach einem der Ansprüche 1 bis 25, wobei das druckübertragende Medium Kaliumchlorid ist.

33. Verfahren nach einem der Ansprüche 1 bis 25, wobei das druckübertragende Medium Cäsiumchlorid ist.

34. Verfahren nach einem der Ansprüche 1 bis 25, wobei das druckübertragende Medium Cäsiumbromid ist.

35. Verfahren nach einem der Ansprüche 1 bis 25, wobei das druckübertragende Medium Kupferchlorid ist.

36. Verfahren nach einem der Ansprüche 1 bis 25, wobei das druckübertragende Medium Kupferbromid ist.

## Revendications

1. Procédé de changement de la couleur d'un diamant, comprenant les étapes consistant à:
i) créer une masse réactionnelle en mettant le diamant dans un milieu de transmission de pression qui entoure complètement le diamant; et
ii) soumettre la masse réactionnelle à une température et une pression élevée pour une période de temps appropriée;
**caractérisé en ce que** le diamant est un diamant de type IIa brun, sa couleur change de brun à incolore, et la masse réactionnelle est soumise à une température dans le domaine de 2200°C à 2600°C sous une pression de 7,6 GPa à 9 GPa.

2. Procédé selon la revendication 1, dans lequel le diamant est un diamant naturel.

3. Procédé selon la revendication 1 ou la revendication 2, dans lequel le diamant possède une concentration d'azote qui est inférieure à 2 ppm, présente une couleur brune à brune rosâtre et possède un spectre d'absorption ultraviolet/visible qui présente une absorption croissante monotone, ou une absorption croissante monotone avec de larges bandes centrées autour de 390 et 550 nm.

4. Procédé selon la revendication 3, dans lequel la concentration d'azote est inférieure à 0,2 ppm.

5. Procédé selon une quelconque des revendications précédentes, dans lequel le diamant possède initialement un spectre d'absorption ultraviolet/visible qui présente une absorption croissante monotone et possède des bandes d'absorption centrées autour de 390 et 550 nm, et, après avoir été soumis à l'étape (ii), présente une réduction ou une suppression effective à la fois de l'absorption croissante monotone et des bandes d'absorption centrées autour de 390 et 550 nm.

6. Procédé selon une quelconque des revendications précédentes, dans lequel la température à l'étape (ii) est dans le domaine de 2500°C à 2550°C.

7. Procédé selon une quelconque des revendications précédentes, dans lequel la période durant laquelle le diamant est soumis aux conditions de l'étape (ii) ne dépasse pas 5 heures.

8. Procédé selon une quelconque des revendications précédentes, dans lequel la période durant laquelle le diamant est soumis aux conditions de l'étape (ii) ne dépasse pas 90 minutes.

9. Procédé selon une quelconque des revendications précédentes, dans lequel la masse réactionnelle dans l'étape (ii) est soumise à un traitement thermique en deux étapes, la masse réactionnelle étant soumise, dans une seconde étape, à une température plus élevée que dans la première étape, dans le domaine fixé dans la revendication 1.

10. Procédé selon la revendication 9, dans lequel dans la première étape, la couleur de diamant est transformée en un rose ou en un brun plus clair et dans la seconde étape la couleur de diamant est transformée d'un rose ou d'un brun plus clair en une teinte incolore.

11. Procédé selon la revendication 9 ou 10, dans lequel la masse réactionnelle dans l'étape (ii) est soumise, dans la première étape, à une température dans le domaine de 1900°C à 2300°C.

12. Procédé selon la revendication 9 ou 10, dans lequel la masse réactionnelle dans l'étape (ii) est soumise, dans la première étape, à une température dans le domaine de 2100°C à 2300°C.

13. Procédé selon la revendication 9 ou 10, dans lequel la masse réactionnelle dans l'étape (ii) est soumise, dans la première étape, à une température allant jusqu'à 2300°C.

14. Procédé selon une quelconque des revendications 9 à 13, dans lequel la masse réactionnelle dans l'étape (ii) est soumise, dans la première étape, à une pression de 6,9 GPa à 8,5 GPa.

15. Procédé selon une quelconque des revendications 9 à 13, dans lequel la masse réactionnelle dans l'étape (ii) est soumise, dans la première étape, à une pression de 7,4 GPa à 8,5 GPa.

16. Procédé selon une quelconque des revendications 9 à 13, dans lequel la masse réactionnelle dans l'étape (ii) est soumise, dans la première étape, à une pression allant jusqu'à 8,5 GPa.

17. Procédé selon une quelconque des revendications 9 à 16, dans lequel la période de traitement thermique dans la première étape est de 10 minutes à 10 heures.

18. Procédé selon une quelconque des revendications 9 à 16, dans lequel la période de traitement thermique dans la première étape est de 20 minutes à 4 heures.

19. Procédé selon une quelconque des revendications 9 à 18, dans lequel la température de traitement thermique dans la seconde étape est de 2500°C à 2550°C.

20. Procédé selon une quelconque des revendications 9 à 18, dans lequel la masse réactionnelle dans l'étape (ii) est soumise, dans la seconde étape, à une pression de 8,4 GPa à 8,6 GPa.

21. Procédé selon une quelconque des revendications 9 à 20, dans lequel la période de traitement thermique dans la seconde étape va jusqu'à 5 heures.

22. Procédé selon une quelconque des revendications 9 à 20, dans lequel la période de traitement thermique dans la seconde étape va jusqu'à 90 minutes.

23. Procédé selon une quelconque des revendications 9 à 20, dans lequel la période de traitement thermique dans la seconde étape est d'environ une heure.

24. Procédé selon une quelconque des revendications précédentes, dans lequel une pluralité de diamants est placée dans le milieu de transmission de pression, chaque diamant étant séparé de son voisin par le milieu de transmission de pression.

25. Procédé selon une quelconque des revendications précédentes, dans lequel le milieu de transmission de pression est un milieu homogène qui entoure complètement le ou chaque diamant et est appliqué sur toute la surface du ou de chaque diamant.

26. Procédé selon une quelconque des revendications précédentes, dans lequel le milieu de transmission de pression possède une faible résistance au cisaillement.

27. Procédé selon une quelconque des revendications précédentes, dans lequel le milieu de transmission de pression est soluble dans l'eau.

28. Procédé selon une quelconque des revendications précédentes, dans lequel le milieu de transmission de pression est un sel d'halogénure métallique.

29. Procédé selon la revendication 28, dans lequel l'halogénure est du bromure ou du chlorure.

30. Procédé selon une quelconque des revendications 1 à 25, dans lequel le milieu de transmission de pression est du bromure de potassium.

31. Procédé selon une quelconque des revendications 1 à 25, dans lequel le milieu de transmission de pression est du chlorure de sodium.

32. Procédé selon une quelconque des revendications 1 à 25, dans lequel le milieu de transmission de pression est du chlorure de potassium.

33. Procédé selon une quelconque des revendications 1 à 25, dans lequel le milieu de transmission de pression est du chlorure de césium.

34. Procédé selon une quelconque des revendications 1 à 25, dans lequel le milieu de transmission de pression est du bromure de césium.

35. Procédé selon une quelconque des revendications 1 à 25, dans lequel le milieu de transmission de pression est du chlorure de cuivre.

36. Procédé selon une quelconque des revendications 1 à 25, dans lequel le milieu de transmission de pression est du bromure de cuivre.
